# EUROPEAN PATENT APPLICATION

(11) **EP 4 675 676 A1**
(43) Date of publication of application: **07.01.2026**
(21) Application number: 25182311.8
(22) Date of filing: 12.06.2025
(51) Int. Cl.: H01L 21/768, H01L 23/48, H01L 25/065, H01L 21/48, H01L 23/31, H01L 23/498, H01L 23/538, H01L 23/00

(54) **DOUBLE-SIDED MULTICHIP PACKAGES WITH DIRECT DIE-TO-DIE COUPLING**

(30) Priority: 01.07.2024 US 202418760635
(71) Applicant: NXP USA, Inc., Austin, TX 78735 (US)
(72) Inventor: Vincent, Michael B, 5656AG Eindhoven (NL); Hayes, Scott M, 5656AG Eindhoven (NL); Gong, Zhiwei, 5656AG Eindhoven (NL)
(74) Representative: Colaiuda, Antonella

(57) **Abstract**

A multi-chip package includes two electronic components bonded to each other via features on corresponding faces of the components that are directly opposite each other. The components are encapsulated in a volume of molding material that can include upper and lower sets of redistribution layers disposed on upper and lower surfaces of the volume of molding material that include electrical interconnects. The package includes one or more internal interconnects that pass through an aperture in the first electronic component to electrically couple an electrical contact on a surface of the package to the second electronic component.

## Description

### TECHNICAL FIELD

**Embodiments** of the subject matter described herein relate to polymeric packages for semiconductor devices and other electronic components and methods of fabricating such packages.

### BACKGROUND

**Semiconductor** devices and other electronic devices are frequently assembled into packages to protect the devices from damage and to provide macroscopic electrical contacts. Packages can be made of various materials including polymers and ceramics. It can be desirable to assemble multiple devices within one package in order to reduce the volume required for various components in larger assemblies. It can also be desirable to interconnect multiple devices within a multi-chip package to save space and/or to improve device performance characteristics such as maximum clock speeds, power dissipation, and the like.

### SUMMARY

**In** an example embodiment, an electronic device package includes a first electronic component having a first surface provided with electrical contact pads and a second surface opposite the first surface; and a second electronic component having a first surface provided with electrical contact pads and a second surface opposite the first surface. The first surface of the second electronic component physically contacts and is bonded to the first surface of the first electronic component.

The electronic device package also includes an aperture that passes through the first electronic component and exposes a first electrical contact pad on the first surface of the second electronic component and a volume of molding material that encapsulates the first electronic component and the second electronic component.

The electronic device package also includes an upper set of redistribution layers formed from layers of electrically-insulating material that surround a first set of electrically conductive interconnects. The upper set of redistribution layers extends from a first surface of the volume of molding material to an upper redistribution layer ("RDL") surface. The electronic device package also includes a lower set of redistribution layers formed from layers of electrically-insulating material that surround a second set of electrically conductive interconnects. The lower set of redistribution layers extends from a second surface of the volume of molding material that is opposite the first surface of the volume of molding material to a lower RDL surface.

The electronic device package also includes an internal interconnect that passes through the volume of molding material and the aperture in the first electronic component. The internal interconnect electrically couples an electrically conductive interconnect in the first redistribution layer to an electrical contact pad belonging to the second electronic component.

In another example embodiment, a method of forming an electronic device package includes providing a first electronic component having a first surface provided with electrical contact pads and a second surface opposite the first surface; and providing a second electronic component having a first surface provided with electrical contact pads and a second surface opposite the first surface.

The method also includes bonding the second electronic component to the first electronic component such that the first surface of the second electronic component physically contacts and is bonded to the first surface of the first electronic component; and forming an aperture that passes through the first electronic component and exposes a first electrical contact pad on the first surface of the second electronic component. The method also includes encapsulating the first electronic component and the second electronic component within a volume of molding material.

The method also includes forming an upper set of redistribution layers from layers of electrically-insulating material that surround a first set of electrically conductive interconnects. The upper set of redistribution layers extends from a first surface of the volume of molding material to an upper redistribution layer ("RDL") surface. The method also includes forming a lower set of redistribution layers from layers of electrically-insulating material that surround a second set of electrically conductive interconnects. The lower set of redistribution layers extends from a second surface of the volume of molding material that is opposite the first surface of the volume of molding material to a lower RDL surface.

The method also includes forming an internal interconnect that passes through the volume of molding material and the aperture in the first electronic component. The internal interconnect electrically couples an electrically conductive interconnect in the first redistribution layer to an electrical contact pad belonging to the second electronic component.

### BRIEF DESCRIPTION OF THE DRAWINGS

This disclosure is illustrated by way of examples, illustrative embodiments, and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate the examples, illustrative embodiments and the like, and to explain various principles and advantages, in accordance with the disclosure, wherein:
FIG. 1 is a cross-sectional illustration of an example multi-chip package according to one or more embodiments.
FIG. 2 is a cross-sectional illustration of steps in an example process suitable for fabricating the multi-chip package of FIG. 1.
FIG. 3A is a cross-sectional illustration of an example process step in one or more embodiments which selectively reduces adhesion between two die upon bonding.
FIG. 3B is a cross-sectional illustration of the result of the process step of FIG. 3A.
FIG. 4 is a cross-sectional illustration of steps in an example process suitable forming apertures in a thick die in one or more embodiments.

### DETAILED DESCRIPTION

The following Detailed Description provides examples for the purposes of understanding and is not intended to limit the embodiments of this Disclosure and uses of the same. Furthermore, there is no intention to be bound by any expressed or implied theory presented in the preceding technical field, background, or the following detailed description.

For simplicity and clarity of illustration, elements in the Drawings are not necessarily drawn to scale. For example, the dimensions of some of the elements or regions in the figures may be exaggerated relative to other elements or regions to help improve understanding of embodiments of the invention. Directional references such as "top," "bottom," "left," "right," "above," "below," and so forth, unless otherwise stated, are not intended to require any preferred orientation, and are made with reference to the orientation of the corresponding figure or figures for purposes of illustration. In addition, the Figures and Detailed Description may omit well-known and conventional features for clarity.

Previous approaches to multichip packaging include so-called "2D integration" and "2.5D integration" in which multiple devices, including semiconductor device substrates (often referred to as "die" or "chips") are placed side-by side on a carrier and then interconnected by routing interconnects through interposers placed above or below the carrier. Other approaches, referred to as "3D integration," can include stacking multiple devices on top of each other and interconnecting them using vias and/or other structures to interconnect the die and components in different layers or tiers in a vertical arrangement.

Previous approaches including those described above can have disadvantages that can be addressed by applying methods disclosed herein to produce multichip packages. As an example, methods for fabricating multichip packages according to embodiments described herein enable the placement of semiconductor die and/or other components having different footprints and thicknesses in dense arrangements by allowing the die and components to be embedded in multiple packaging layers and/or across the layers. Embodiments described herein also allow for direct bonding of two or more devices to each other. In one or more embodiments, the direct bonds are also used to form electrical interconnections between two or more of the devices.

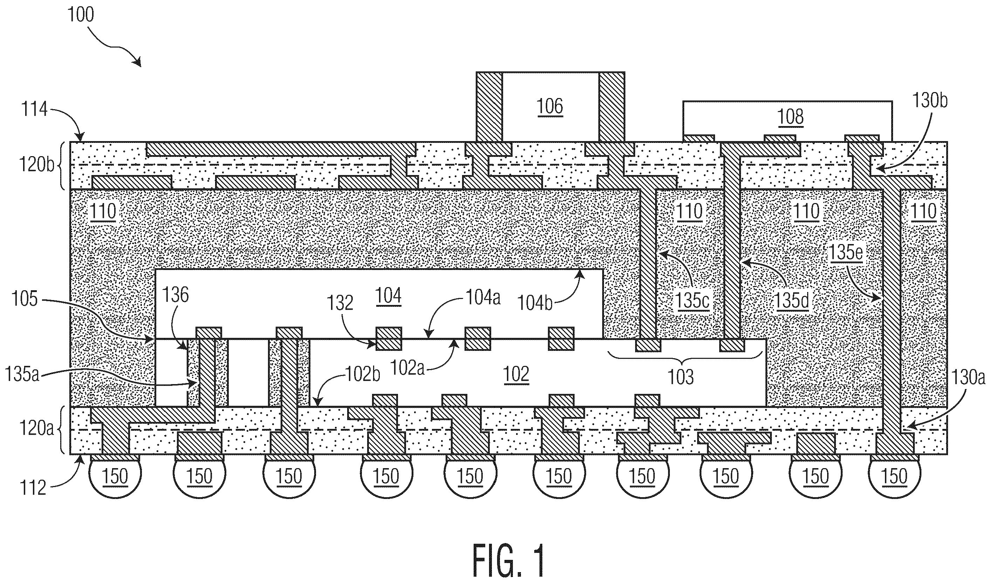

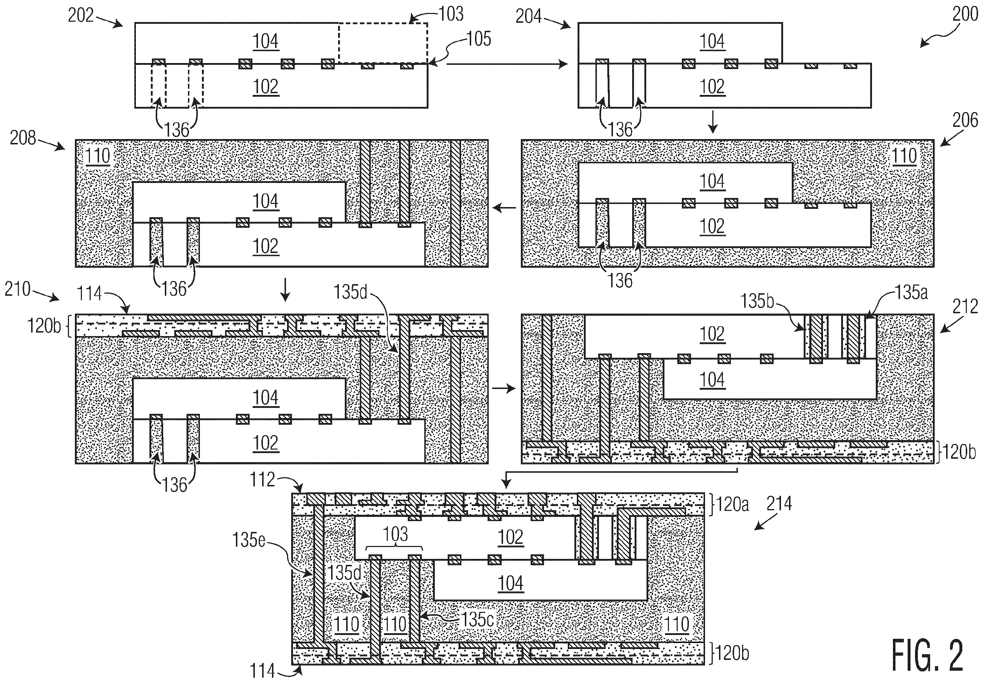

Along these lines, FIG. 1 shows an example package 100 according to embodiments herein. Methods of fabricating the example package 100 and similar multichip packages will be discussed further below in connection with FIG. 2. The example package 100 is at least partially formed by a volume of molding material 110 that encapsulates at least a first die 102 and a second die 104. Accordingly, embodiments herein can accommodate a wide range of die footprints and thickness by adjusting the thickness or other dimensions of the volume of molding material 110.

The die 102 has a first surface 102a and second surface 102b opposite the surface 102a. Similarly, the die 104 has a first surface 104a and second surface 104b opposite the surface 104a. The die 102, 104 are directly bonded to each other at their respective first surface 102a, 104a. As shown, the die 102, 104 include metal features 132 which can be used to (at least partially) bond the die 102 to the die 104 via direct metallurgical bonding of corresponding metal features 132 on each of the surfaces 102a, 104a to each other. Alternatively, or in in addition, the surfaces 102a, 104a can be at least partially bonded to each via direct bonding of exposed silicon (or other semiconductor materials which can be directly bonded to each other) on each surface 102a, 104a to corresponding material on the opposite die or direct bonding of other materials such as silicon dioxide or other suitable oxide materials.

It will be understood that although the second surface 102b of the die 102 is depicted as flush with the surrounding molding material 110 and the second surface 104b of the die 104 is depicted as separated from the redistribution layers 120b by a portion of the volume of molding material 110, that nothing herein is intended to require any particular depth of die such as the die 102, 104 within a volume of molding material such as the molding material 110. For instance, the second surface 102b of the die 102 could be covered by any suitable thickness of the molding material 110 and the second surface 104b of the die 104 could be in direct contact with the redistribution layers 120b, described below.

The molding material 110 and related molding materials herein can be any suitable material including, as one nonlimiting example, epoxy molding compound (EMC) which can include silica and other fillers. As shown, the package 100 includes a first set of redistribution layers 120 (the redistribution layers 120a) and a second set of redistribution layers 120 (the redistribution layers 120b), separated from each other by the volume of molding material 110. Redistribution layers 120 may be formed using any suitable materials, including, as nonlimiting examples: polyimide, epoxy, polybenzoxazole (PBO), Ajinomoto build-up film (ABF) coating, or dry film materials. In one or more embodiments, one or more redistribution layers 120 are formed from the same material as the volume of molding material 110. In one or more embodiments, each redistribution layer (e.g., a redistribution layer 120) is formed from the same material as each other redistribution layer, while in one or more other embodiments, one or more different materials are used for certain redistribution layers.

The example package 100 also includes a component 106 and a component 108 disposed on top of a set of laminated redistribution layers 120 having electrically conductive interconnects 130 routed within (for brevity, such electrically-conductive interconnects may be referred to as electrical interconnects or simply interconnects). In this example, the component 106 is representative of discrete component such as a resistor, capacitor, or the like which may be significantly thicker than electronic device die similar to the die 102, 104. The component 108 is representative of more compact components such as semiconductor die with bottom contacts configured for surface-mounting via direct bonding or solder reflow, as non-limiting examples. Embodiments herein can also accommodate various additional die, packaged die, or other components disposed above redistribution layers 120 and the routing of the interconnects 130 as needed to accommodate a particular set of die and/or other components.

As explained further below, interconnects 130 in one or more embodiments herein can be routed within the redistribution layers 120 and the volume of molding material 110 to provide connections between components disposed on or within different portions of a package (e.g., the package 100) and also to provide connections to external contact structures (e.g., the solder bumps 150). In the example of FIG. 1, the package 100 has a lower redistribution layer surface (the lower RDL surface 112) and an upper redistribution layer surface (the upper RDL surface 114). Interconnects 130 extend through the redistribution layers 120 to provide external contact areas that are provided with solder bumps 150 to allow the package 100 to be placed on a circuit board, for example. It will be understood that the package 100 is shown with solder bumps 150 on a lower redistribution layer surface (the lower RDL surface 112) for purposes of illustration and that embodiments herein are not limited to utilizing solder bumps or any other specific bonding technologies. Furthermore, it will be appreciated that packages according to embodiments herein are not limited to having electrical contacts on only one surface, or only type of electrical contacts.

It will be understood that packages according to embodiments herein may include a greater or fewer number of die than pictured in FIG. 1 and that various arrangements of die with varying sizes and configurations are possible. For example, in embodiments herein, a package may include die configured to be electrically coupled to contacts (i.e., interconnects 130) using any number of suitable methods, including examples ball bonding, thermocompression bonding, flip chip bonding, solder reflow bonding, and so on as nonlimiting examples.

The bulk of multichip packages according to embodiments herein (e.g., the package 100 as shown in FIG. 1) can be formed entirely from polymeric materials (e.g., molding material 110 and additional polymeric materials forming redistribution layers 120), in contrast to other 3D integration or substrate embedding approaches that require the use of selectively hollowed out printed circuit boards with one or more core layers selectively removed to allow placement of die within voids in the circuit board(s). Advantageously, methods herein allow die having widely disparate sizes and thickness to be integrated within a single package, and, as shown in FIG.1, it is not necessary in embodiments herein that any particular die be disposed at the same depth as other any die, as in many previous approaches.

In the example of FIG. 1, the die 102 includes an additional set of contacts on its second surface 102b. These contacts can be used as additional electrical interconnections to components on or within the die 102 and can also be used for other purposes such as thermal dissipation and/or electrical grounding, as nonlimiting examples. The contacts on the second surface 102b may also be connected to contacts on the first surface 102a or other structures using through-substrate vias (not shown). Similarly, although not shown in FIG. 1, in one or more embodiments a die such as the die 104 can include contacts on a second surface such as the second surface 104b that are similar the contacts on the surface 102b of the die 102.

In this example, the die 102 and 104 are positioned "face to face" with the first surface 102a of the die 102 bonded to the first surface 104a of the die 104 such that the second surface 102b of the die 102 is facing toward lower RDL surface 112 and the second surface 104b of the die 104 is facing toward the upper RDL surface 114.

Metal features such as the metal features 132 In the example of FIG. 1 can also be used to electrically couple die such as the die 102, 104 to each other. The metal features 132 are depicted as metallic contacts or other structures at the surfaces 102a, 104a of the respective die 102, 104 that extend into the die in FIG. 1. However, it will be understood that metal features such as the metal features 132 can be formed using any suitable methods and materials, and that die such as the die 102, 104. As indicated above, individual metal features can be used to help bond two die to each other, to electrically interconnect two die or to perform one or both of these functions, as may be desired in various applications. When a metal feature such as a metal feature 132 is used as an electrical contact or otherwise part of an electrical interconnect, it may also be referred to as an electrical contact, a contact pad, or the like.

As shown, the additional components 106, 108 are disposed above the second set of redistribution layers 120b and electrically coupled to various interconnects 130b. As above, the component 106 is illustrative of components such as a discrete resistors, capacitors, and inductors which may be significantly thicker than a semiconductor device die. The component 106 can also be illustrative of substrates and packages containing multiple discrete components. In one or more embodiments such components are incorporated into a multichip package using techniques described further below in connection with FIG. 2, for example.

The package 100 includes external contacts (e.g., solder bumps 150 as shown in FIG. 1) which are bonded and electrically coupled to portions of the interconnects 130 that extend through the redistribution layers 120 to the lower RDL surface 112 of the package 100. The package 100 also includes one or more internal interconnects 135 (e.g., the internal interconnects, 135a,135b, 135c, 135d, and 135e in FIG. 1).

In the example of FIG. 1, the die 102, 104 are stacked in an offset arrangement in which an extended portion 103 of the surface 102a extends beyond the footprint of the die 104 This arrangement allows for the die 102, 104 to be interconnected as shown while allowing access to the die for internal interconnects 135 to electrically couple the die 102, 104 to interconnects 130 or other contact structures (e.g., solder bumps 150) on either surface of the volume of molding material 110.

As a result in embodiments disclosed herein, internal interconnects can originate within a first redistribution layer (e.g., one of the redistribution layers 120a or one of the redistribution layers 120b), and pass through a portion of a volume of molding material such as the volume of molding material 110 to electrically couple a die such as the die 102 or the die 104 within the molding material to one or more corresponding electrical interconnects. For example, the internal interconnects 135a, 135b pass through the volume of molding material 110 and electrically couple electrical interconnects 130a of the redistribution layers 120a to contacts on the surface 104a of the die 104 by passing through apertures formed in the intervening die 102. In another example, the internal interconnects 135c, 135d pass through the volume of molding material 110 and electrically couple electrical interconnects 130b of the redistribution layers 120b to contacts on the surface 102a of the die 102. As will be described further below in connection to FIG. 2, the arrangement of the interconnects such as the interconnects 135c, 135d relative to a die surface can be achieved by direct bonding of two die in an arrangement such as the arrangement shown in FIG. 1 or, two die can be bonded to each other and one or more of the die can be subsequently patterned to expose previously buried portions of their surfaces at an interface (e.g., the interface 105 between the die 102, 104) between the two die.

Internal interconnects according to embodiments herein can originate within a first redistribution layer (e.g., one of the redistribution layers 120a or one of the redistribution layers 120b), and can pass through the entire thickness of a volume of molding material (e.g., the volume of molding material 110) to terminate in another redistribution layer on an opposite surface of the volume of molding material 110 (e.g., one or more of the redistribution layers 120a or one or more of the redistribution layers 120b). For example, the internal interconnect 135e passes through the volume of molding material 110 and electrically couples one of the electrical interconnects 130a of the redistribution layers 120a to one of the electrical interconnects 130b of the redistribution layers 120b (thereby coupling the component 108 on the upper RDL surface 114 to a solder bump on the lower RDL surface 112).

Internal interconnects according to embodiments herein can also enable direct contact from an interconnect within a redistribution layer to a die through a volume of molding material (e.g., the internal interconnect 135a, 135b and the internal interconnects 135c, 135d). Accordingly, in one or more embodiments, an internal interconnect electrically interconnects an interconnect or component at an upper RDL surface (e.g., a component 106 or 108 on the upper RDL surface 114) to a die within a volume of molding material such as the volume of molding material 110 (e.g., the die 102). In one or more embodiments, an internal interconnect electrically interconnects an interconnect or component at a lower RDL surface (e.g., an interconnect 130b and/or a solder bump 150) to a die within a volume of molding material such as the volume of molding material 110 (e.g., the die 104). In one or more embodiments, an internal interconnect (e.g., a metal feature 132, which may also be referred to as a direct interconnect) may be used to electrically interconnect a first die inside the volume of molding material 110 (e.g., the die 102) to a second die within a volume of molding material (e.g., the die 104).

It will be understood that the description of the package 100 above is intended as an example and that nothing herein is intended to limit embodiments to only two die molded within a package, such as the package 100, to any specific number of internal interconnects 135 or to any specific number of components on an RDL surface such as the upper RDL surface 114. It will also be understood that components such as the component 106, 108 or any other suitable components may be attached to an RDL surface such as the upper RDL surface 114 by any suitable methods including ball bonding, compression bonding, solder reflow and the like and that different component may be attached by different methods. It will be further understood that embodiments herein may have different combinations of one or more features described in connection with the example of FIG. 1 and subsequent figures.

Furthermore, in embodiments herein, die such as the die 102, 104 and similar components can be completely surrounded by molding material (e.g., the die 104 as depicted in FIG. 1) or they can be positioned with a surface that contacts one of the redistribution layers. For example, the die 102 is depicted in FIG. 1 with its second surface 102b directly contacting the redistribution layer120a closest to the volume of molding material 110. As shown, a die such as the die 102 can have contacts on two surfaces. For example, the die 102 is shown with contacts on its second surface coupled to interconnects 130a within the redistribution layers 120a.

FIG. 2 illustrates steps in an example process for fabricating a multichip package (e.g., the package 100 of FIG. 1) according to embodiments herein. Accordingly, FIG. 2 illustrates the steps 202, 204, 206, 208, 210, 212and 214, of the process 200 which are described below with reference to the package 100 and the components shown in FIG. 1. It will be understood that the steps described below are non-limiting examples only and that multiple individual steps may be combined in each step for ease of understanding, and that the structures shown can be formed as described or in related processes which may add additional steps, omit steps below, or perform those steps or related steps in a different order than described.

First, at step 202, the die 102 is bonded to the die 104, forming the interface 105 between the two die. As described above, the bonding may be accomplished by bonding of the two die at respective metal features 132; by bonding of semiconductor, oxide, or other materials of the two die 102, 104 to each other; or by a combination of such bonding processes. In one or more embodiments, in which features such as the metal features 132 do not participate in the bonding process, such features may be absent. In one or more embodiments, in which features such as the metal features 132 do not participate in the bonding process, such features may be recessed with respect to the two die surfaces which are ultimately bonded to form an interface such as the interface 105.

In this example, the die 102, 104 are the same width when they are bonded together, and dashed regions indicate the locations of the apertures 136 in the die 102 and the extended portion 103 of the surface 102a which can be formed at a later step. In one or more alternative processes, the apertures 136 in the die 102 can be formed before the die 102, 104 are bonded. Similarly, in one or more related processes, the die 104 can be patterned before the die 102, 104 are bonded such that the extended portion 103 of the die 102 is present as soon as the die 102, 104 are bonded. Along similar lines, although the die 102, 104 are bonded in a die-level process in the example process 200, those skilled in the art will appreciate that multiple die can be bonded together and patterned simultaneously in a panel-level or wafer-level processes and that, in such processes, the panels or wafers can be singulated at any suitable point during fabrication. Any suitable tools and methods can be used to secure and position the die 102, 104 during the bonding process including, as non-limiting examples, mechanical fixtures such as vacuum chucks or platens. Die or wafers can also be temporarily affixed to carrier substrates using adhesives or other materials.

At step 204, the apertures 136 in the die 102 are formed by any suitable process, non-limiting examples of which include lithographic processes that include wet chemical etching steps, dry plasma etching steps, laser etching, mechanical drilling or the like. The die 104 may also be sawn, etched, otherwise patterned using any suitable methods to remove the portion of the substrate required to form the exposed portion 103 of the surface 102a of the die 102.

At step 206, the bonded die 102, 104 are encapsulated with a volume of the molding material 110, including filling of the apertures 136 in the die 102 with the molding material 110. Before the die are encapsulated, the apertures 136 may be lined with an insulating material such as oxide or nitride-based electrically insulating material using any suitable methods including, as non-limiting examples, known techniques such as thermal evaporation, sputtering, chemical vapor deposition (CVD), atomic layer deposition (ALD) and any suitable combinations thereof. In related processes all or part of one or more steps of the process 200 can be performed in other orderings than those described above. For example, in one or more embodiments, apertures such as the aperture 136 in a die such as the die 102 can be formed before the die is bonded to another die such as the die 104.

The molding material 110 may be formed by any suitable process. As nonlimiting examples, the molding material 110 may be dispensed as a liquid, powder, dry film, or paste and compression or injection molded around the die 102, 104, followed by a thermally-activated, chemically-activated, or light-activated curing process, or any other suitable process. The lower RDL surface 112 and the upper RDL surface 114 of the package 100 will ultimately be formed on opposite surfaces of the volume of molding material 110, as shown in FIG. 1. The molding material can be left as shown in step 206 or the molding material 110 can be selectively removed (i.e., thinned) above the die 104, the die 102, or both if desired using any suitable processes including dry polishing, wet polishing, and/or chemical-mechanical polishing (CMP).

At step 208, the internal interconnects 135c, 135d, and 135e are formed by any suitable methods. For example, holes can be patterned in the volume of molding material 110 by etching, drilling, or any other suitable technique and filled with metal using a suitable metal deposition processes, non-limiting examples of which include known techniques such as plating, sputtering, thermal evaporation, paste printing, jetting or the like.

At step 210, one or more redistribution layers 120 (i.e., redistribution layers 120b, including the upper RDL surface 114) that include electrically conductive interconnects 130 (i.e., interconnects 130b) are formed and directly electrically coupled to the internal interconnects 135c, 135d, 135e as shown. It will be appreciated that the number of redistribution layers 120 and sequencing of the formation of those layers can vary depending on specific die to be incorporated in the resulting package and the number and arrangement of desired electrical connections to those die.

The redistribution layers 120 and the interconnects 130 within those layers, as shown in FIG. 2 and elsewhere, can be formed in a sequential manner using any suitable processes. As one nonlimiting example, a first layer of interconnects 130 may be deposited and patterned on an exposed surface of the molding material 110, followed by depositing dielectric material around them to complete the first redistribution layer 120b. This process may be repeated to build up subsequent redistribution layers 120 including respective portions of the interconnects 130 within. As another nonlimiting example, the interconnects can be formed at least in part using electroplating processes or any other suitable methods.

At step 212, the internal interconnects 135a,b are formed by drilling through or otherwise selectively removing the molding material 110 in the apertures 136 that pass through the die 102 followed by deposition of metal by any suitable methods (e.g., those described above in connection with formation of the internal interconnects 135c, 135d, 135e).

At step 214, one or more redistribution layers 120 (i.e., redistribution layers 120a, including the lower RDL surface 112) that include electrically conductive interconnects 130 (i.e., interconnects 130a) are formed on the opposite side of the volume of molding material 110 and directly electrically coupled to the internal interconnects 135a, 135b as shown. It will be appreciated that the number of redistribution layers 120 and sequencing of the formation of those layers can vary depending on specific die to be incorporated in the resulting package and the number and arrangement of desired electrical connections to those die.

Following step 214, additional components (e.g., components 106, 108) can be coupled to the upper RDL surface 114 as shown in FIG. 1. In one or more embodiments, the upper RDL surface 114 and components disposed on the upper RDL surface 114 are encapsulated in an additional volume of molding material 110 disposed on the upper RDL surface 114 (not shown).

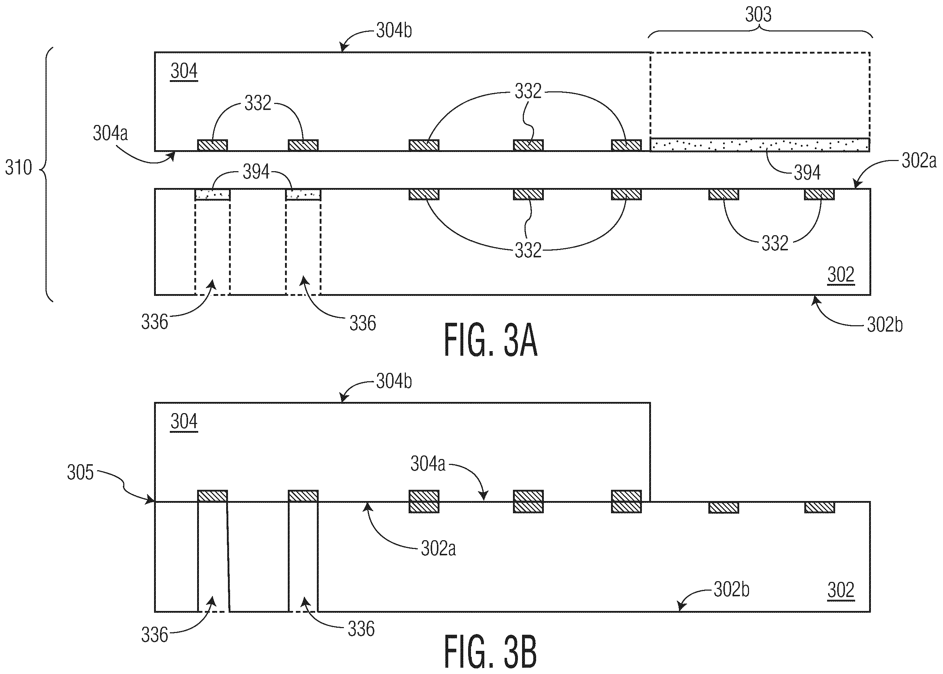

FIG. 3A is a cross-sectional illustration of an example process step (or sub-process) that can be used in one or more embodiments to bond two or more die such as the die 302 (e.g., a die 102) and the die 304 (e.g., a die 104). The die 302, 304 are shown with metal features 332 (e.g., metal features 132) in similar locations to the metal features 132 of the die 102, 104 as pictured in FIG. 1 and FIG. 2.

In the process step 310, the surface 302a of the die 302 and the surface 304a of the die 304 are modified to reduce adhesion at regions 394 during subsequent bonding of the two die. The die surfaces can be modified mechanically, chemically, or both. For instance, a thin layer of material may be applied to the regions 394 that inhibits stiction (e.g., a self-assembled fluorinated monolayer or other suitable material). Alternatively, or in addition the surfaces in the regions 394 may be etched or abraded to produce surface that is roughened, recessed, or both with respect to the unmodified portion(s) of each surface. Such mechanical modification can be accomplished by any suitable methods including, but not limited to: wet chemical etching, dry plasma etching (including sputter etching, reactive ion etching, or a combination thereof), laser cutting, or the like.

It will be appreciated that, after the regions 394 are modified, bonding between the die surfaces 302a, 304a will be most likely to occur (or stronger) at the unmodified areas, such as at the metal features 332. This can be desirable in certain applications because the risk of accidental stiction between die during the manufacturing process can be reduced. This can be particularly advantageous if the two die are bonding along with other die in a wafer-level process before the die are singulated from larger wafers. The result of the process step 310 is shown in FIG. 3B which shows the die 302, 304 bonded to each other along a resulting interface 305 (e.g., an interface 105), following formation of the apertures 336 and removal of the portion 303 of the die 304. Surface modifications such as those just described can also be advantageous when a die such as the die 302 or 304 must be subsequently etched, e.g., to remove a portion 303 of the die 304 or to create apertures such as the apertures 336 in the die 302 (e.g., apertures 136 in the die 102) because reduced stiction at an interface such as the 305 can facilitate removal of material from the interface when a die is etched after being bonded to another die.

It will be appreciated that the process step 310 can be performed as part of a process such as the process 200 described above (e.g., before the step 202). It will also be appreciated that nothing herein requires that each sub-step of the process step 310 be performed simultaneously. For example, the die 302, 304 may be processed at different times before they are bonded to each other. It will also be understood that, in one or more embodiments, a process step similar to the process step 310 is applied to only one die (e.g., to only the die 302, or to only the die 304).

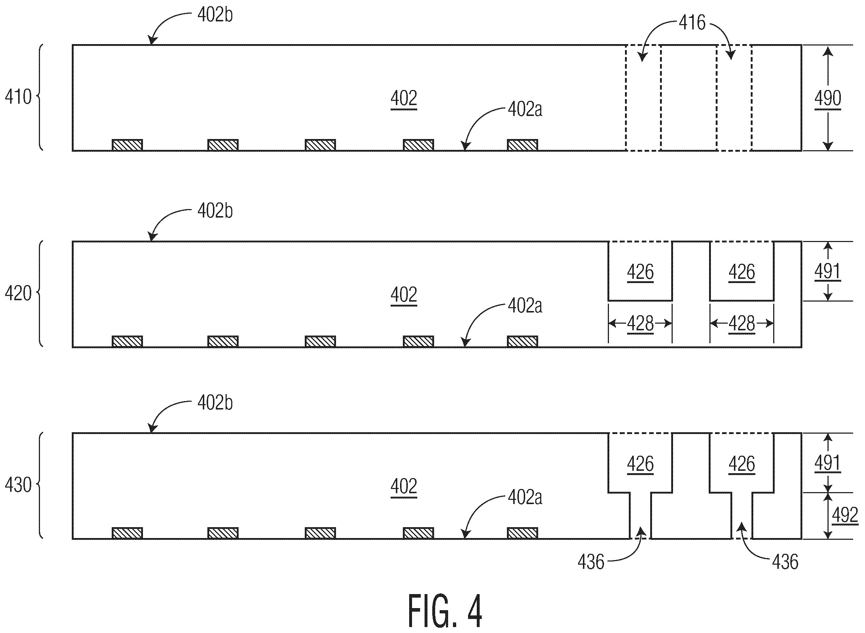

FIG. 4 illustrates steps in an example process (or sub-process) that can be used to fabricate apertures (e.g., apertures 136, 336) in a die for use in a multichip package (e.g., the package 100 of FIG. 1) according to embodiments herein. Accordingly, FIG. 4 illustrates the steps 410, 420, and 430 of the process 400 which are described below with reference to a die 402 with surfaces 402a, 402b (e.g., a die 102 as depicted in FIG. 1 and FIG. 2). The process 400 can facilitate formation of apertures such as apertures 136 or 336 when a die is relatively thick (e.g., 0.3 - 1 mm, as one nonlimiting example) and it would be difficult to etch or otherwise pattern the die with a uniform diameter straight-through aperture (e.g., as pictured in FIG. 1, FIG. 2, and FIG. 3). The process 400 or related processes can be performed in conjunction with another process such as the process 200 of FIG. 2.

At step 410 a die 402 (e.g., a die 102, 104, 302, or 304) with surfaces 402a and 402b is provided. The die 402 has a thickness 490. Locations of the desired equivalent uniform apertures 416 (e.g., apertures 136, 336) are indicated by dashed rectangles within the outline of the die 402. At step 420, the die 402 is patterned by etching trenches 426 that extend into the die 402. The trenches 426 have a depth 491 that is less than the total thickness 490 of the die 402 and have widths 428 that are greater than the width of the equivalent uniform apertures 416. The trenches 426 can be formed by any suitable process(es) including, as non-limiting examples: laser etching, wet chemical etching, reactive ion etching, mechanical drilling or the like. At step 430, apertures 436 are formed at the bottom of each trench 426 and extend a further depth 492 to the surface 402a of the die 402. Together the trenches 426 and apertures 436 form a single chamfered aperture having more than one width as shown in FIG 4. The apertures 436 can be formed by any suitable process(es) including, as non-limiting examples: laser etching, wet chemical etching, reactive ion etching, mechanical drilling or the like.

As above, examples herein are not intended to limit embodiments to a particular arrangement of stacked die in packages such as the packages 100 and related packages described in connection with FIGs. 1-4. As indicated above, embodiments herein are not limited to only two die or other components with a volume of molding material.

It will be understood that the packages such as the package 100, are examples for the purposes of illustration and are not intended to limit embodiments to any one configuration of die and other components or any one configuration of redistribution layers and interconnects. Thus, a package according to embodiments herein may have any suitable number and arrangement of die and other components; any suitable number and arrangement of redistribution layers with conductive interconnects; and any suitable number and arrangement of internal interconnects, direct interconnects, through-substrate vias, and the like. Furthermore, packages according to embodiments herein may include die of different sizes, thickness, and shapes and can include additional substrates such as printed circuit boards, and the like.

### EXAMPLES

Features of embodiments may be understood by way of one or more of the following examples:
Example 1: an electronic device package or method that includes a first electronic component having a first surface provided with electrical contact pads and a second surface opposite the first surface; and a second electronic component having a first surface provided with electrical contact pads and a second surface opposite the first surface. The first surface of the second electronic component physically contacts and is bonded to the first surface of the first electronic component. An aperture passes through the first electronic component and exposes a first electrical contact pad on the first surface of the second electronic component.

**A** volume of molding material encapsulates the first electronic component and the second electronic component. An upper set of redistribution layers is formed from layers of electrically-insulating material that surround a first set of electrically conductive interconnects. The upper set of redistribution layers extends from a first surface of the volume of molding material to an upper redistribution layer (RDL) surface. A lower set of redistribution layers is formed from layers of electrically-insulating material that surround a second set of electrically conductive interconnects. The lower set of redistribution layers extends from a second surface of the volume of molding material that is opposite the first surface of the volume of molding material to a lower RDL surface. An internal interconnect passes through the volume of molding material and the aperture in the first electronic component. The internal interconnect electrically couples an electrically conductive interconnect in the first redistribution layer to an electrical contact pad belonging to the second electronic component.

Example 2: The electronic device package or method of Example 1 where the first surface of the first electronic component is at least partially bonded to the first surface of the second electronic component by a metallurgical bond between an electrical contact on the first surface of the first electronic component and a corresponding electrical contact on the first surface of the second electronic component.

Example 3: The electronic device package or method of Example 1 or Example 2 where the first electronic component and the second electronic component are electrically coupled to each other via corresponding electrical contact pads on the first surface of the first electronic component and on the first surface of the second electronic component that are bonded to each other.

Example 4: The electronic device package or method of any of Examples 1-3 where the aperture in the first electronic component is chamfered such the aperture is wider at the second surface of the first electronic component than it is at the first surface of the first electronic component.

Example 5: The electronic device package or method of any of Examples 1-4 where an interface between the first surface of the first electronic component and the first surface of the second electronic component includes an area of modified where adhesion between the first surface of the first electronic component and the first surface of the second electronic component is reduced compared to a remaining portion of the interface.

Example 6: The electronic device package or method of Example 5 where surface roughness of the first surface of the first electronic component in the area of modified adhesion is greater than surface roughness of the first surface of the first electronic component along a remaining portion of the interface.

Example 7: The electronic device package or method of Example 5 or Example 6 where surface roughness of the first surface of the second electronic component in the area of modified adhesion is greater than surface roughness of the first surface of the second electronic component along a remaining portion of the interface.

Example 8: The electronic device package or method of any of Examples 5-7 where the area of modified adhesion includes a portion of the first surface of the first electronic component that has a lower surface energy compared to the remaining portion of the interface.

Example 9: The electronic device package or method of any of Examples 5-8 where the area of modified adhesion includes a portion of the first surface of the second electronic component that has a lower surface energy compared to the remaining portion of the interface.

Example 10: The electronic device package or method of any of Examples 1-9 wherein a first edge of the first electronic component extends past an edge of the second electronic component such an electrical contact on the first surface of the first electronic component are exposed within the volume of molding material.

Example 11: The electronic device package or method of any of Examples 1-10 that also includes an electrical interconnect that directly electrically couples the electrical contact on the first surface of the first electronic component to an electrical interconnect in the upper set of redistribution layers.

The preceding detailed description and Figures referenced therein are examples. They are illustrative in nature and are not intended to limit the embodiments of the Disclosure and uses of such embodiments. It should therefore be understood that embodiments of this Disclosure are not limited in their application to the details of construction and the arrangement of components set forth in the preceding Description or illustrated in the accompanying Figures.

The connecting lines shown in the various figures contained herein are intended to represent exemplary functional relationships and/or physical couplings between the various elements. It should be noted that many alternative or additional functional relationships or physical connections may be present in one or more embodiments of this Disclosure.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description. It is to be understood that other phraseology and terminology used herein is for the purpose of description and should not be regarded as limiting.

The terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. Herein, "A, B, and/or C" is defined as "A or B or C" or any combination of A, B, or C.

As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations of the figures may depict exemplary arrangements of elements, additional intervening elements, devices, features, or components may be present in one or more embodiments of the depicted subject matter.

The terms "first," "second" and other such numerical terms referring to structures do not imply a sequence or order unless clearly indicated by the context. Thus, the terms "first," "second," "third," "fourth" and the like in the description and the claims, if any, may be used for distinguishing between similar elements and not necessarily for describing a particular sequential or chronological order. It is to be understood that numerical terms used herein are interchangeable under appropriate circumstances such that the embodiments of the invention described herein are, for example, capable of operation in sequences other than those illustrated or otherwise described herein.

As used herein the terms "approximate," "approximately," "substantial" and "substantially" mean sufficient to accomplish the stated purpose in a practical manner and that minor imperfections, if any, are not significant for the stated purpose. Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described.

While at least one exemplary embodiment has been presented in the foregoing detailed description, it should be appreciated that a vast number of variations exist. It should also be appreciated that exemplary embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An electronic device package, comprising:
a first electronic component having a first surface provided with electrical contact pads and a second surface opposite the first surface;
a second electronic component having a first surface provided with electrical contact pads and a second surface opposite the first surface, wherein the first surface of the second electronic component physically contacts and is bonded to the first surface of the first electronic component;
an aperture that passes through the first electronic component and exposes a first electrical contact pad on the first surface of the second electronic component;
a volume of molding material that encapsulates the first electronic component and the second electronic component;
an upper set of redistribution layers formed from layers of electrically-insulating material that surround a first set of electrically conductive interconnects, wherein the upper set of redistribution layers extends from a first surface of the volume of molding material to an upper redistribution layer ("RDL") surface;
a lower set of redistribution layers formed from layers of electrically-insulating material that surround a second set of electrically conductive interconnects, wherein the lower set of redistribution layers extends from a second surface of the volume of molding material that is opposite the first surface of the volume of molding material to a lower RDL surface; and
an internal interconnect that passes through the volume of molding material and the aperture in the first electronic component;
wherein the internal interconnect electrically couples an electrically conductive interconnect in the first redistribution layer to an electrical contact pad belonging to the second electronic component.

2. The electronic device package of claim 1, wherein the first surface of the first electronic component is at least partially bonded to the first surface of the second electronic component by a metallurgical bond between an electrical contact on the first surface of the first electronic component and a corresponding electrical contact on the first surface of the second electronic component.

3. The electronic device package of claim 1 or claim 2,
wherein the first electronic component and the second electronic component are electrically coupled to each other via corresponding electrical contact pads on the first surface of the first electronic component and on the first surface of the second electronic component that are bonded to each other.

4. The electronic device package according to any preceding claim,
wherein the aperture in the first electronic component is chamfered such the aperture is wider at the second surface of the first electronic component than it is at the first surface of the first electronic component.

5. The electronic device package according to any preceding claim,
wherein an interface between the first surface of the first electronic component and the first surface of the second electronic component includes an area of modified where adhesion between the first surface of the first electronic component and the first surface of the second electronic component is reduced compared to a remaining portion of the interface.

6. The electronic device package of claim 5, wherein:
surface roughness of the first surface of the first electronic component in the area of modified adhesion is greater than surface roughness of the first surface of the first electronic component along a remaining portion of the interface; or
surface roughness of the first surface of the second electronic component in the area of modified adhesion is greater than surface roughness of the first surface of the second electronic component along the remaining portion of the interface.

7. The electronic device package of claim 5,
wherein the area of modified adhesion includes a portion of the first surface of the first electronic component or a portion of the first surface of the second electronic component that has a lower surface energy compared to the remaining portion of the interface.

8. The electronic device package according to any preceding claim,
wherein a first edge of the first electronic component extends past an edge of the second electronic component such an electrical contact on the first surface of the first electronic component are exposed within the volume of molding material.

9. The electronic device package of claim 8, further comprising an electrical interconnect that directly electrically couples the electrical contact on the first surface of the first electronic component to an electrical interconnect in the upper set of redistribution layers.

10. A method of forming an electronic device package, the method comprising:
providing a first electronic component having a first surface provided with electrical contact pads and a second surface opposite the first surface;
providing a second electronic component having a first surface provided with electrical contact pads and a second surface opposite the first surface;
bonding the second electronic component to the first electronic component such that the first surface of the second electronic component physically contacts and is bonded to the first surface of the first electronic component;
forming an aperture that passes through the first electronic component and exposes a first electrical contact pad on the first surface of the second electronic component;
encapsulating the first electronic component and the second electronic component within a volume of molding material;
forming an upper set of redistribution layers from layers of electrically-insulating material that surround a first set of electrically conductive interconnects, wherein the upper set of redistribution layers extends from a first surface of the volume of molding material to an upper redistribution layer ("RDL") surface;
forming a lower set of redistribution layers from layers of electrically-insulating material that surround a second set of electrically conductive interconnects, wherein the lower set of redistribution layers extends from a second surface of the volume of molding material that is opposite the first surface of the volume of molding material to a lower RDL surface; and
forming an internal interconnect that passes through the volume of molding material and the aperture in the first electronic component;
wherein the internal interconnect electrically couples an electrically conductive interconnect in the first redistribution layer to an electrical contact pad belonging to the second electronic component.

11. The method of claim 10, wherein the first surface of the first electronic component is at least partially bonded to the first surface of the second electronic component by a metallurgical bond between an electrical contact on the first surface of the first electronic component and a corresponding electrical contact on the first surface of the second electronic component.

12. The method of claim 10 or claim 11,
wherein the first electronic component and the second electronic component are electrically coupled to each other via corresponding electrical contact pads on the first surface of the first electronic component and on the first surface of the second electronic component that are bonded to each other.

13. The method of any of claims 10 to 12,
wherein the aperture in the first electronic component is chamfered such the aperture is wider at the second surface of the first electronic component than it is at the first surface of the first electronic component.

14. The method of any of claims 10 to 13, further comprising:
forming, at an interface between the first surface of the first electronic component and the first surface of the second electronic component, an area of modified adhesion between the first surface of the first electronic component and the first surface of the second electronic component where adhesion between the first electronic component and the second electronic component is reduced compared to a remaining portion of the interface.

15. The method of claim 14, wherein:
surface roughness of the first surface of the first electronic component in the area of modified adhesion is greater than surface roughness of the first surface of the first electronic component along a remaining portion of the interface; or
surface roughness of the first surface of the second electronic component in the area of modified adhesion is greater than surface roughness of the first surface of the second electronic component along the remaining portion of the interface.
